# EUROPEAN PATENT APPLICATION

(11) **EP 4 745 587 A1**
(43) Date of publication of application: **20.05.2026**
(21) Application number: 24213216.5
(22) Date of filing: 15.11.2024
(51) Int. Cl.: G01R 31/12, G08B 13/24, G08B 17/06

(54) **IMPROVED SECURITY MONITORING SYSTEM**

(71) Applicant: Verisure Sàrl, 1290 Versoix (CH)
(72) Inventor: PIEDBOIS, Julien, 1290 Versoix (CH)
(74) Representative: Hansson Thyresson AB

(57) **Abstract**

There is provided a method of operating a security monitoring system of a premises, the method comprising: detecting, by an electrical discharge detector of the security monitoring system, an electrical discharge in electrical wiring of the premises; and in response to the detection, altering a state of at least one sensor of the security monitoring system from a first state to a second state. There is also provided a security monitoring system comprising: at least one electrical discharge detector configured to detect an electrical discharge in electrical wiring; and at least one sensor configurable between a first state and a second state; wherein the system is configured to alter the sensor from the first state to the second state in response to detection of an electrical discharge by the electrical discharge detector.

## Description

### TECHNICAL FIELD

The present invention relates to a security monitoring system for monitoring of a premises, and more particularly to a security monitoring system comprising an electrical discharge detector for detecting electrical discharges in electrical wiring of the premises, and to methods of operating the same.

### BACKGROUND

Security installations that are or include security monitoring systems for monitoring premises (e.g. a building such as a home), often referred to as alarm systems, typically provide means for detecting undesirable security or safety events and reacting to detected events. Such detection means may include presence sensors, motion sensors and/or perimeter sensors for monitoring an area of the premises and detecting an unauthorized intruder entering or moving within or around the premises. Additionally, or alternatively, the means may include fire detection means such as a smoke detector for detecting smoke likely originating from a fire inside the premises.

Such systems may be self-contained, with alarm indicators such as sirens and flashing lights that may be activated when an undesirable security or safety event is detected. Alternatively, or additionally, such systems may be linked to a remote monitoring centre where, typically, human operators manage the responses required by different alarm and notification types.

Hence, the security monitoring systems can alert a user (e.g. a homeowner) or an operator (e.g. at a remote monitoring centre or at the emergency services) that an undesirable security or safety event has occurred. Accordingly, such security monitoring systems contribute to the safety and wellbeing of occupants of the protected premises as well as safeguarding articles within the protected premises.

However, a smoke detector may only detect smoke after a fire has generated a sufficient amount of smoke. At this point in time, the occupants of the premises and/or the premises themselves (e.g. if no occupants are present in the premises) may face significant danger even if the security monitoring system alerts the occupant (e.g. by a siren), an operator and/or the emergency services.

From the above, it is understood that there is room for improvements in security monitoring systems, and the invention aims to solve or at least mitigate the above and other problems. Accordingly, embodiments of the present invention seek to provide enhanced security monitoring systems, methods and other implementations that improve the scope of such systems to address aspects of the safety and security as well as providing new functionality and methods.

### SUMMARY

The invention is defined by the appended independent claims. Additional features and advantages of the concepts disclosed herein are set forth in the description which follows, and in part will be obvious from the description, or may be learned by practice of the described technologies. The features and advantages of the concepts may be realized and obtained by means of the instruments and combinations particularly pointed out in the appended claims. These and other features of the described technologies will become more fully apparent from the following description and appended claims, or may be learned by the practice of the disclosed concepts as set forth herein.

It is an objective of embodiments to provide a security monitoring system capable of monitoring electrical wiring in a premises such that the security monitoring system may detect electrical discharges that could potentially precede electrical fires. It is a further objective of embodiments to provide a security monitoring system with an improved alertness and/or potential fire detection performance.

In a first aspect, there is provided a method of operating a security monitoring system of a premises. The method comprises: detecting, by an electrical discharge detector of the security monitoring system, an electrical discharge in electrical wiring of the premises; and in response to the detection, altering a state of at least one sensor of the security monitoring system from a first state to a second state.

The operating method thus allows electrical discharges that could potentially precede electrical fires to be detected and, in response thereto, an alertness of the security monitoring system is increased. Thus, a potential fire detection performance of the security monitoring system is improved.

The at least one sensor may be any sensor of a security monitoring system, and mat for example comprise a presence sensor, a thermal sensor, a radiation-based sensor, an infrared sensor, a motion sensor, a photosensor, a smoke detection sensor, a temperature sensor, an image capturing sensor, or any combination thereof.

In embodiments, the method may further comprise monitoring, using the sensor in the second state, an area of the premises. For example, a user and/or operator may monitor an output from the sensor in the second state. Alternatively and/or additionally, the monitoring may be performed, for example automatically, by the security monitoring system and/or the sensor.

The sensor in the second state may be configured to monitor a parameter indicative of a potential fire in the premises. For example, the indicative parameter may include a smoke amount, a temperature, an incident light amount (e.g. of one or more specific wavelengths such as wavelengths corresponding to one or more target colours), an incident heat amount, an incident radiation (e.g. thermal radiation, infrared radiation) amount, or any combination thereof.

The method may further comprise transmitting an alert signal in response to a value of the parameter being indicative that a fire has potentially started in the premises. The parameter may be considered indicative of a potential fire if the parameter value changes in a way that is consistent with what is expected if a potential fire has started in the premises, e.g. based on a comparison of the parameter value with one or more reference or threshold values. For example, the parameter may be considered indicative of a potential fire if the parameter value exceeds a threshold value, such as if a detected smoke amount exceeds a threshold value. As another example, the parameter may be considered indicative of a potential fire if the parameter value falls below a threshold value, such as if a visibility parameter falls below a threshold (e.g. due to the line of sight being obscured by smoke). As yet another example, the parameter may be considered indicative if the parameter value increases and/or decreases by a predetermined amount (e.g. relative to an initial and/or reference value), for example within a predetermined time period (e.g. a short time period indicating a sudden change in the parameter value), such as if there is a sudden increase in temperature and/or thermal (e.g. infrared) radiation.

The altering of the at least one sensor from the first state to the second state may comprise any one or more of: activating the sensor; increasing the sensitivity of the sensor; and putting the sensor into a fire detection mode.

Optionally, at least one of the sensors comprises a temperature sensor, wherein the temperature sensor in the second state is configured to monitor a temperature in the premises, optionally, wherein the method comprises transmitting an alert signal in response to the monitored temperature exceeding a temperature threshold, optionally, wherein the temperature threshold in the second state is lower than a temperature threshold in the first state.

Optionally, at least one of the sensors comprises a thermal radiation-based sensor, such as an infrared sensor, wherein the thermal radiation-based sensor in the second state is configured to monitor an amount of incident thermal radiation, optionally, wherein the method comprises transmitting an alert signal in response to the amount of incident thermal radiation exceeding a radiation threshold, optionally, wherein the incident thermal radiation threshold in the second state is lower than an incident thermal radiation threshold in the first state.

Optionally, at least one of the sensors comprises a smoke detection sensor configured to detect smoke, the smoke detection sensor having a smoke detection threshold, optionally, wherein the smoke detection sensor in the second state has a lower smoke detection threshold than the smoke detection threshold in the first state, optionally, wherein the method comprises transmitting an alert signal in response to the smoke detected exceeding the smoke detection threshold.

Optionally, at least one of the sensors comprises an image capturing sensor, wherein the method further comprises determining an amount of target colours in a field of view of the image capturing sensor, optionally, wherein the method further comprises transmitting an alert signal in response to the determined amount exceeding a target colour threshold.

The method according to the first aspect may further comprise: determining a severity of the detected electrical discharge; and in response to the determined severity exceeding a severity threshold, triggering an alarm, optionally, wherein the triggering of the alarm comprises activating a siren within the premises.

Additionally, or alternatively, the method may further comprise: determining an area of the premises in which the electrical discharge has occurred, and identifying at least one sensor of the security monitoring system configured to monitor at least part of the determined area, wherein the sensor that is altered from the first state to the second state comprises the identified sensor.

Optionally, the electrical discharge detector comprises a plug inserted into an outlet of the electrical wiring.

Optionally, the step of detecting the electrical discharge comprises: measuring an electrical signal waveform of the electrical wiring; identifying one or more transient signals within the waveform; and determining an occurrence of the electrical discharge in dependence on transient characteristics of the one or more transient signals.

In a second aspect, there is provided a security monitoring system for monitoring of a premises, the security monitoring system comprising: at least one electrical discharge detector configured to be connected to an outlet of electrical wiring in the premises, wherein the electrical discharge detector is configured to detect an electrical discharge in the electrical wiring; and at least one sensor configurable between a first state and a second state; wherein the system is configured to alter the sensor from the first state to the second state in response to detection of an electrical discharge by the electrical discharge detector.

The second state may comprise any one or more of: an active state, a high-sensitivity state; and a fire detection mode.

The at least one sensor may be any sensor of a security monitoring system, and may, for example, include a presence sensor, a thermal sensor, a radiation-based sensor, an infrared sensor, a motion sensor, a photosensor, a smoke detection sensor, a temperature sensor, an image capturing sensor, or any combination thereof.

The security monitoring system may be configured to perform or execute the method of the first aspect. In particular, the sensor may further be configured to, in the second state, monitor an area of the premises. Alternatively, or additionally, the sensor may be configured to transmit monitoring data to one or more devices, such as a user device, a remote monitoring centre device, or the like.

The sensor in the second state may be configured to monitor a parameter indicative of a potential fire in the premises. The security monitoring system may further be configured to transmit an alert signal in response to a value of the parameter being indicative that a fire has potentially started in the premises.

Optionally, at least one of the sensors is or comprises a temperature sensor, wherein the temperature sensor in the second state is configured to monitor a temperature in the premises, optionally, wherein the security monitoring system is configured to transmit an alert signal in response to the monitored temperature exceeding a temperature threshold, optionally, wherein the temperature threshold in the second state is lower than a temperature threshold in the first state.

Optionally, at least one of the sensors is or comprises a thermal radiation-based sensor, such as an infrared sensor, wherein the thermal radiation-based sensor in the second state is configured to monitor an amount of incident thermal radiation, optionally, wherein the security monitoring system is configured to transmit an alert signal in response to the amount of incident thermal radiation exceeding a radiation threshold, optionally, wherein the incident thermal radiation threshold in the second state is lower than an incident thermal radiation threshold in the first state.

Optionally, at least one of the sensors is or comprises a smoke detection sensor configured to detect smoke, the smoke detection sensor having a smoke detection threshold, optionally, wherein the smoke detection sensor in the second state has a lower smoke detection threshold than the smoke detection threshold in the first state, optionally, wherein the security monitoring system is configured to transmit an alert signal in response to the smoke detected exceeding the smoke detection threshold.

Optionally, at least one of the sensors is comprises an image capturing sensor, wherein the security monitoring system is configured to determine an amount of target colours in a field of view of the image capturing sensor, optionally, wherein the security monitoring system is configured to transmit an alert signal in response to the determined amount exceeding a target colour threshold.

Optionally, the security monitoring system is further configured to determine a severity of the detected electrical discharge; and in response to the determined severity exceeding a severity threshold, trigger an alarm, optionally, wherein the triggering of the alarm comprises activating a siren within the premises.

Optionally, the security monitoring system is further configured to determine an area of the premises in which the electrical discharge has occurred, and identify at least one sensor of the security monitoring system configured to monitor at least part of the determined area, wherein the sensor that is altered from the first state to the second state comprises the identified sensor.

Optionally, the electrical discharge detector comprises a plug inserted into an outlet of the electrical wiring. Optionally, the electrical discharge detector is configured to: measure an electrical signal waveform of the electrical wiring; identify one or more transient signals within the waveform; and determine an occurrence of the electrical discharge in dependence on transient characteristics of the one or more transient signals.

### BRIEF DESCRIPTION OF THE DRAWINGS

In order to best describe the manner in which the above-described embodiments are implemented, as well as define other advantages and features of the disclosure, a more particular description is provided below and is illustrated in the appended drawings. Understanding that these drawings depict only exemplary embodiments of the invention and are not therefore to be considered to be limiting in scope, the examples will be described and explained with additional specificity and detail through the use of the accompanying drawings in which:
- Fig. 1a: is a schematic view of a security monitoring system according to embodiments;
- Fig. 1b: is a schematic view of a security monitoring system according to embodiments of the invention;
- Fig. 2: is a schematic view of an electrical discharge detector according to embodiments;
- Fig. 3: is a flowchart of an electrical discharge detection method according to embodiments;
- Fig. 4: is flowchart of a method of operating a security monitoring system according to embodiments;
- Fig. 5: is flowchart of a method of operating a security monitoring system according to embodiments;
- Fig. 6: is flowchart of a method of operating a security monitoring system according to embodiments; and
- Fig. 7: is flowchart of a method of operating a security monitoring system according to embodiments.

Further, in the figures like reference characters designate like or corresponding parts throughout the several figures. The first digit in the reference character denotes the first figure in which the corresponding element or part appears.

### DETAILED DESCRIPTION

Various embodiments of the disclosed methods and arrangements are discussed in detail below. While specific implementations are discussed, it should be understood that this is done for illustration purposes only. A person skilled in the relevant art will recognize that other components, configurations, and steps may be used without parting from the spirit and scope of the claimed invention.

Hereinafter, certain embodiments will be described more fully with reference to the accompanying drawings. It will be apparent to those skilled in the art that various modifications and variations can be made without departing from the inventive concept. Other embodiments will be apparent to those skilled in the art from consideration of the specification and practice disclosed herein. It is to be understood that elements and materials may be substituted for those illustrated and described herein, parts and processes may be reversed or omitted, certain features may be utilized independently, and embodiments or features of embodiments may be combined, all as would be apparent to the skilled person in the art.

The embodiments herein are provided by way of example so that this disclosure will be thorough and complete, and will fully convey the scope of the inventive concept, and that the claims be construed as encompassing all modifications, equivalents and alternatives of the present inventive concept which are apparent to those skilled in the art to which the inventive concept pertains. If nothing else is stated, different embodiments may be combined with each other.

Although reference may be made to directions (e.g. left, right, up, down, upper, lower) as shown in the figures, it will be appreciated that these references are purely for illustrative purposes, and that embodiments are not limited to such directions.

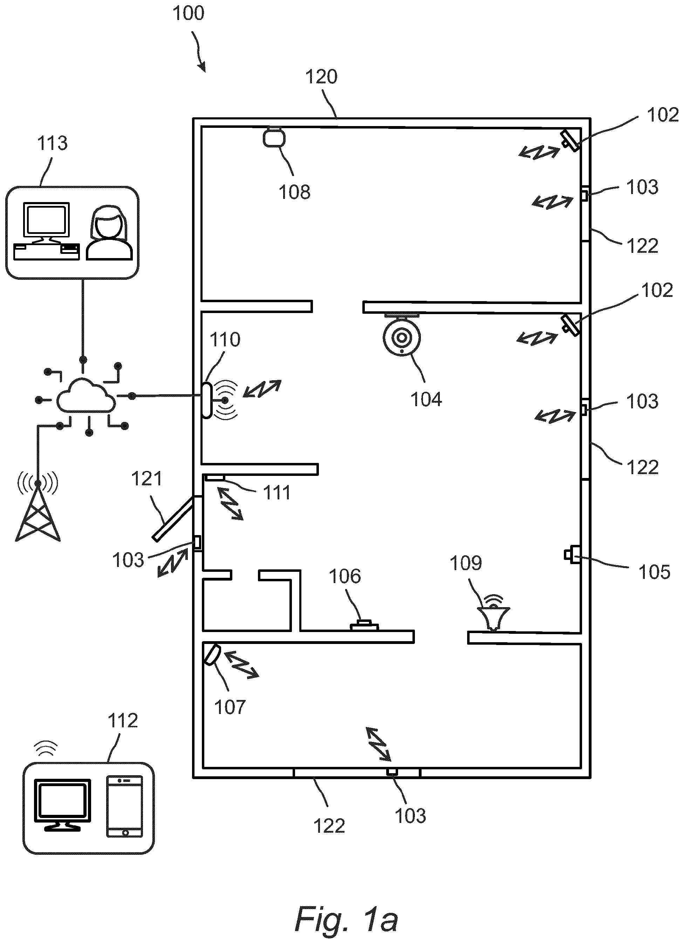

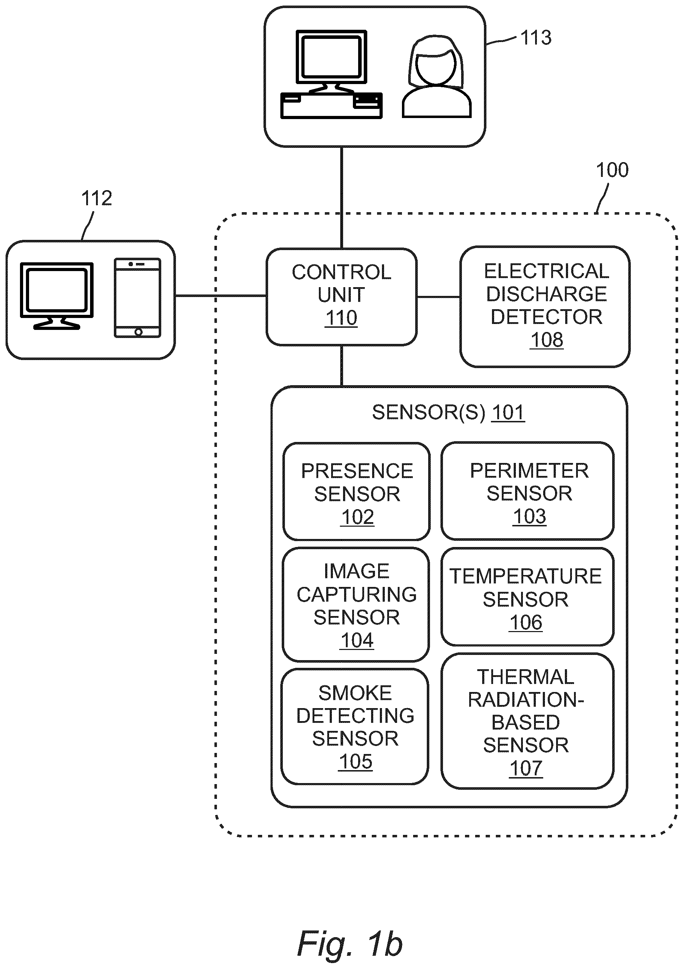

Figs. 1a and 1b show a security monitoring system 100 arranged in premises 120 in the form of a building. The security monitoring system 100 may also be referred to as an alarm system. The premises 120 may be a residential building such as a house or an apartment, and/or a commercial building such as an office building, or the like.

The security monitoring system 100 comprises one or more sensors 101 for monitoring of the premises 120. For example, the sensors 101 may monitor an interior area of the premises 120. While monitoring the premises 120, the sensors 101 may be configured to detect an alarm-incurring event (e.g. an undesirable security or safety event or hazard), such as an intruder and/or a fire.

The security monitoring system 100 may, for instance, include one or more sensors 101 for detecting an intruder entering or moving within the premises. Such sensors 101 may comprise one or more presence sensors 102, one or more perimeter sensors 103, one or more image capturing sensors 104, or a combination of one or more thereof. Additionally, or alternatively, the security monitoring system 100 may include a sensor 101 for detecting a fire within the premises 120. For example, the security monitoring system 100 may comprise a smoke detecting sensor 105 (i.e. a smoke detector) configured to detect smoke inside the premises 120. The security monitoring system 100 may further comprise one or more temperature sensors 106 for monitoring a temperature within the premises 120, and/or one or more other sensors 101 for monitoring one or more parameters and/or characteristics of the premises 120 or its interior.

A presence sensor 102 may be defined as a sensor 101 sensitive to the presence of persons and/or objects within an area monitored by the presence sensor 102. Presence sensors 102 may include motion or passage sensors sensitive to motion or passage of a person and/or object within the premises 120. The presence sensor 102 may thus comprise any type of sensor or detector capable of detecting presence, and/or movement of a person and/or object. For example, the presence sensor 102 may comprise a thermal radiation-based sensor 107 for detecting an amount of incident thermal radiation, or the like. In particular, the presence sensor 102 may include an infrared sensor such as a thermal-MOS (TMOS) sensor and/or a passive infrared sensor (also referred to as a PIR sensor). Other examples of presence sensors 102 include photosensors, optical sensors, visual sensors, thermal sensors, radiation-based sensors and/or image capturing means such as a camera.

A perimeter sensor 103, on the other hand, may be defined as a sensor 101 configured to detect persons and/or objects crossing or breaching a perimeter of the premises 120. Exemplary perimeter sensors 103 include magnetic sensors arranged at windows 122 and/or doors 121, and/or glass breakage sensors (such as a shock sensor) for detecting breakage of e.g. a window 122 or glass door.

In embodiments, the security monitoring system 100 may comprise at least one sensor 101 comprising image capturing means, such as a camera (e.g. a photographic camera), video camera or any other type of type of optical sensing device capable of capturing or acquiring one or more still and/or moving images of its field of view. Such a sensor 101 may accordingly be referred to as an image capturing sensor 104. The image capturing sensor 104 may be configured to provide (e.g. capture) one or more images of an area of the premises 104 in its field of view. For instance, the image capturing sensor 104 may capture images of the room in which it is located.

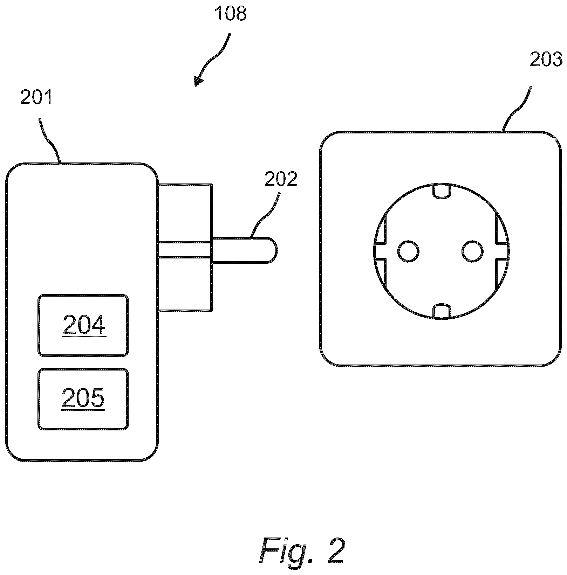

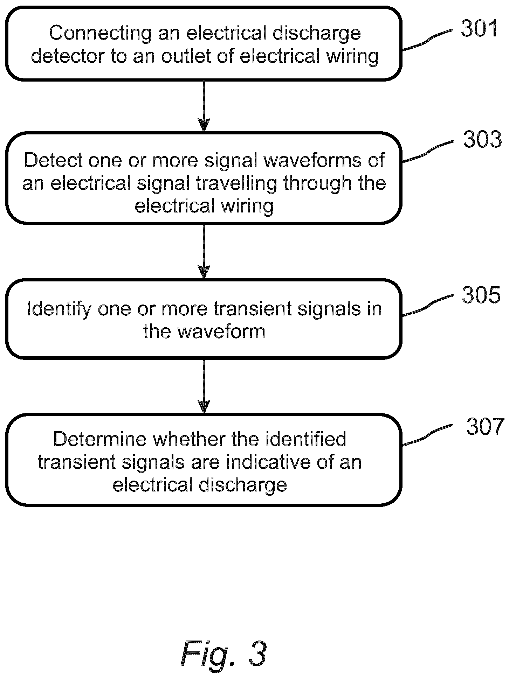

In addition to the above-described sensors 101, the security monitoring system 100 according to embodiments comprises at least one electrical discharge detector 108 for detecting electrical discharges in the electrical wiring of the premises 120. The electrical discharge detector 108 will be described further in relation to Figs. 2 and 3.

The security monitoring system 100 may comprise one or more alarm indicators 109 such as a visual alarm indicator (e.g. a flashing light), an audible alarm indicator (e.g. a siren), or the like, that may be activated in the event of an alarm-incurring event being detected.

The security monitoring system 100 may further comprise a control unit 110 which may also be referred to as a central unit. The control unit 110, which may generally be mains powered, is coupled or connected to the sensors 101 and the electrical discharge detector 108, and is configured to process received signals and determine a response. The sensors 101 and the electrical discharge detector 108 may, for example, be provided with wireless (e.g. via Wi-Fi, radio frequency, or the like) and/or wired communication means for communicating with the control unit 110. In particular, the sensors 101 may be coupled to the control unit 110 using transceivers that may operate in the industrial scientific and medical (ISM) bandwidths, for example a sub-gigahertz bandwidth such as 868 MHz, and the communications may be encrypted preferably using shared secret keys.

The control unit 110 may include a processor and an alert triggering unit for providing an alert signal when the security monitoring system 100 is triggered or set off, e.g. when an alarm-incurring event has occurred.

The control unit 110 may also be connected to input means 111 allowing a user to interact with the control unit 110. The input means 111 may be a keypad or similar, for arming and disarming the sensors 101 so as to arm and disarm the security monitoring system 100. In the illustrated embodiment, the input means 111 is arranged in the vicinity of the entrance door 121.

The control unit 110 may communicate with one or more user devices 112, which may be almost any kind of electronic device such as a smartphone, tablet, laptop or desktop computer, a smart watch, or even a television. For example, the control unit 110 may communicate with an app or other program installed on such user devices 112 allowing the user to interact with the control unit 110 and/or the security monitoring system 100. The user device 112 may also be loaded with a public land mobile network (PLMN) by means of which the control unit 110 (and/or a remote monitoring centre 113 as will be described later), may communicate with the user device 112. The user device 112, and in particular the app or program installed thereon, may thus form input means 111 to the control unit 110 such that the user can, though the user device 112, instruct the control unit 110 to arm or disarm the security monitoring system 100, or the like. The user device 112 may also provide the user with information relating to a state of the security monitoring system 100 (e.g. if it is in an armed or disarmed state) and/or one or more of its sensors 101. The security monitoring system 100 may accordingly notify the user via the user device(s) 112 if and when the security monitoring system 100 is set off or triggered.

The control unit 110 may further be connected to a remote monitoring centre 113, which is located remotely from the premises 120. The control unit 110 may accordingly be configured to transmit alert signals to the remote monitoring centre 113, where operators (i.e. human operators) and/or computerised systems manage the alert signals and determines an appropriate action. That is, the control unit 110, typically located in the premises 120, is configured to process notifications and signals received from the sensors 101 and/or the electrical discharge detector 108, and to notify the remote monitoring centre 113 of at least some of these signals that are indicative of an alarm-incurring event (e.g. an undesirable security or safety event), depending upon the settings of the system and the nature of the detected events. In such a configuration, the control unit 110 at the installation is effectively acting as a gateway between the sensors 101 and the remote monitoring centre 113.

The control unit 110 may be connected to the remote monitoring centre 113 by wires, such as a telephone line, or by a wireless telecommunications system such as GSM or other radio frequency systems. The connection may also be through the in-ternet or any other suitable network.

Hence, operation of the security monitoring system 100 may be controlled by one or more of: the control unit 110, the remote monitoring centre 113, and a security monitoring app installed on the user device 112. For example, the remote monitoring centre 113, if provided, may receive one or more signals from any of the sensors 101 and/or the electrical discharge detector 108. The remote monitoring station 113 may transmit commands for controlling any one or more of: the arm state of the security monitoring system 100 (e.g. armed or unarmed), commanding a tripped alarm state to be signalled by the security monitoring system 100 (e.g. by triggering one or more alarm indicators 109 to generate alarm noise), commanding operation of one or more functions of the sensors 101 and/or electrical discharge detector 108. Communication with the remote monitoring centre 113 may pass through the control unit 110. In other embodiments without the remote monitoring centre 113, or should communication with the remote monitoring centre 113 be interrupted, operation of the security monitoring system 100 may be controlled by the control unit 110. In yet other embodiments, the control unit 110 may be omitted, and the sensors 101 and/or the electrical discharge detector 108 may instead communicate independently with the remote monitoring centre 113, for example, via wireless communication (such as Cat-M LTE).

Howsoever the communication is implemented, the remote monitoring centre 113 may alert one or more operators of an alarm-incurring event. The one or more operators may monitor communications received from the security monitoring system 100. Thus, the one or more operators may, in response to an alert signal being transmitted, send a patrol unit and/or the emergency services to the premises 120 and/or notify an owner or resident of the premises 120.

Fig. 2 shows an electrical discharge detector 108 according to embodiments. The electrical discharge detector 108 comprises a detection unit 201 and a plug 202 for connection to an electrical outlet 203 (e.g. a socket) of the electrical wiring of the premises. Hence, the plug 202 is configured to electrically couple the detection unit 201 to the electrical wiring. The detection unit 201 is thus configured to measure an electrical signal of the electrical wiring at the location where the electrical discharge detector 108 is connected.

Here it is noted that the electrical wiring may comprise one or more circuits in a power distribution system within the premises. The electrical wiring may thus be configured to transfer electrical power from a feeder cable (feeding the premises with electrical power) to branch wires or circuits which in turn feed the power to appliances and outlets 203 in the premises 120. Hence, the electrical discharge detector 108 is intended to be connected directly to the electrical wiring by insertion of the plug 202 into a standard electrical outlet 203. The electrical discharge detector 108 may accordingly be installed without the need for an electrician.

The detection unit 201 of the electrical discharge detector 108 may comprise a processing module 204 and a communication module 205. The processing module 204 may comprise signal capturing means for capturing the electrical signals travelling through the electrical wiring as waveform data, a signal converter such as an analog-to-digital signal converter, a signal amplifier, and/or one or more filters for filtering out 50Hz and/or 60Hz signals and/or electrical noise generated by appliances and devices connected to the electrical wiring. The filters and/or amplifiers may be achieved using hardware and/or software.

In some embodiments, at least part of the processing is performed remotely from the electrical discharge detector 108, for example on a server, at the control unit 110, at the remote monitoring centre 113, or the like. That is, the electrical discharge detector 108 may be configured to transmit the measured electrical signal to a remotely located processor which may be configured to process and analyse the received electrical signal.

The communication module 205 may comprise (wired and/or wireless) means for communicating (i.e. transmitting and/or receiving signals) with the central unit 110, the remote monitoring centre 113, one or more user devices 112, and/or the emergency services.

The electrical discharge detector 108 is configured to detect electrical discharges in the electrical wiring of the premises 120. The electrical discharges may also be referred to as electrical arcs or electrical arc faults.

Electrical discharges typically occur when the integrity of an electrical wire or its insulation is compromised. For example, the electrical wire or its insulation may be damaged (e.g. physical damage, and/or water damage), corroded, aged, or the like, or one or more connections between the electrical wire and another electrical component may have come loose. Such damage may lead to sporadic electrical discharges within the wire and/or between the wire and another electrical conductor.

As the electrical discharges continue over time, the damage or erosion to the insulation or other materials surrounding the wire is worsened, increasing the intensity of the electrical discharges. Hence, after sufficient time has passed, the electrical discharges may become high-power, continuous and high-temperature discharges which may eventually result in the ignition of a spark or fire in the material in which the electrical wiring is arranged which is often combustible (e.g. wood and/or insulation in the walls of the premises 120).

It is accordingly important to detect electrical discharges in electrical wiring as early as possible to reduce the risk of a fire. Hence, by detecting electrical discharges, a user (e.g. the occupant of the premises) and/or the emergency services can be alerted to the faulty electrical wiring, hopefully in time to prevent a fire from starting and/or put out a fire at an early stage. The electrical discharge detector 108 may accordingly improve a fire safety aspect of the security monitoring system 100.

As the electrical discharges give rise to a sharp electromagnetic impulse (e.g. an impulse of current) that travel through the electrical wiring, the electrical discharge detector 108 can detect the electrical discharges by monitoring the electrical signals travelling through the electrical wiring and identifying any impulses likely to originate from an electrical discharge. The method of detection of electrical discharges will be described in more detail in relation to Fig. 3.

It is noted that the electrical signals captured by the electrical discharge detector 108 includes signals transmitted within, to, and from the full electrical wiring. Thus, a single electrical discharge detector 108 is capable of sensing electrical discharge signals throughout the full electrical wiring, including electrical discharges occurring on other branch circuits of the electrical wiring. This is contrary to techniques using arc-fault circuit interrupters (AFCI), where the AFCI must be installed in each electrical outlet and/or in each electrical wiring circuit in the premises in order to detect electrical discharges on each of the individual branch circuits.

Upon detection of an electrical discharge, the electrical discharge detector 108 may be configured to transmit a signal to the control unit 110. Additionally, or alternatively, the electrical discharge detector 108 may be configured to transmit an alert signal directly to the remote monitoring centre 113, a user device 112, and/or the emergency services.

The electrical discharge detector 108 may additionally be configured to notify an occupant of the premises 120 of the detected electrical discharge. The electrical discharge detector 108 may accordingly comprise one or more notification means for notifying a user. The notification means may comprise a visual notification means (e.g. a flashing light), an audible notification means (e.g. a siren), or the like.

Although references have been made to a single electrical discharge detector 108, it is appreciated that the security monitoring system 100 may comprise a plurality of electrical discharge detectors 108 arranged in different outlets 203 of the electrical wiring. The plurality of electrical discharge detectors 108 may be used in simultaneously and in combination to increase the detection sensitivity. The plurality of electrical discharge detectors 108 may additionally or alternatively work together to provide approximate information on the likely location of the electrical discharges within the electrical wiring.

Fig. 3 shows a method of detecting an electrical discharge by the electrical discharge detector 108 according to embodiments. It will be appreciated that the detection method of Fig. 3 is purely exemplary, and embodiments also include detection of electrical discharges by any other suitable method.

In step 301, the electrical discharge detector 108 is connected to an outlet of the electrical wiring of the premises 120.

In step 303, the electrical discharge detector 108 senses or detects an electrical signal travelling through the electrical wiring of the premises 120. In particular, the electrical discharge detector captures one or more signal waveforms (e.g. voltage and/or current waveforms) generated by electrical activity in or connected to the electrical wiring.

In step 305, the electrical discharge detector 108 identifies one or more transient signals in the waveform. Because electrical discharges involve an impulse change in current (as explained previously), the electrical signal generated or caused by said electrical discharge is transmitted along the electrical wiring which can be identified by the electrical discharge detector 108 as transient signals. Accordingly, the electrical discharge detector 108 is configured to detect a change in the signal waveform data in order to identify one or more transient signals in the waveform. The identification of transient signals may be performed using any known method or process, including but not limited to processes involving binning of sampled waveform data, use of floating thresholds of samples in the waveform data, calculation of derivates and/or maximums, or the like.

In step 307, the electrical discharge detector 108 analyses the identified transient signals to determine whether the identified transient signals are indicative of an electrical discharge. For example, the electrical discharge detector 108 may generate and analyse one or more transient characteristics in dependence on the identified transient signals. The generation of transient characteristics may be performed using any known method or process, including but not limited to, methods involving calculating the average transient amplitude over a full voltage cycle and/or for phase sections within the voltage cycle, calculating the amplitude, pulse width, integral and/or rise time of peaks of the transient, or the like.

In analysing the transient characteristics, the electrical discharge detector 108 may identify one or more electrical discharge indicators in the transient characteristics, for example by comparing the transient characteristics to reference data and characteristics, and/or data associated with previously detected electrical discharges, which may be stored in a memory of the electrical discharge detector 108.

As an example, the electrical discharge detector 108 may reconstruct the signal waveform using the generated transient characteristics and compare the distribution of transients in the reconstructed waveform to an expected or reference transient distribution. Here it is noted that the transient signals generated by an electrical discharge travel along the electrical wiring being reflected at any junction. The signals caused by the electrical discharge experience a delay in returning which is dependent on the length of the wire, as well as exhibiting a phase shift.

Hence, if the comparison shows that the transients occur in phase and/or in a regular or repeatable pattern, the transients are likely a result of (normal) operation of a device or appliance connected to the electrical wiring. Alternatively, if the comparison shows that the transients are out of phase and/or in an irregular pattern, this indicates that the transients are a likely result of one or more electrical discharges.

As another example, the electrical discharge detector 108 may compare the generated transient characteristics to reference characteristics data and/or reference characteristics thresholds using any known or suitable method. For instance, the electrical discharge detector 108 may determine the average peak ratio of transients in phase sections of the voltage cycle close to maximum voltage to transients in phase sections of the voltage cycle close to zero voltage, and compare the determined ratio with a threshold value where, if the ratio is above the threshold value, the transient signals are determined as being indicative of an electrical discharge. As another example, the electrical discharge detector 108 may determine if the number of peaks in the transient exceeds a threshold and/or if the rise time for the one or more of the peaks is greater than a threshold. If so, the transient may be determined to be indicative of an electrical discharge.

In some embodiments, the electrical discharge detector 108 may calculate a likelihood value of an electrical discharge having occurred, for example in dependence on how irregular and/or out of phase the transient signals are and/or how far above/below the characteristics are from one or more thresholds. The likelihood value may then be compared to a threshold value to determine whether an electrical discharge has been detected.

In some embodiments, the analysis of transient characteristics may be improved by machine learning techniques, e.g. for determining appropriate threshold levels and/or appropriate reference data.

Once a transient signal has been determined to be indicative of an electrical discharge, i.e. when a likely electrical discharge has been detected, the electrical discharge detector 108 may transmit a signal to the control unit 110, one or more sensors 101 of the security monitoring system 100, the remote monitoring centre 113, one or more user devices 112, and/or the emergency services. The electrical discharge detector 108 may additionally notify an occupant of the premises 120 of the detected electrical discharge using visual and/or audible notification means.

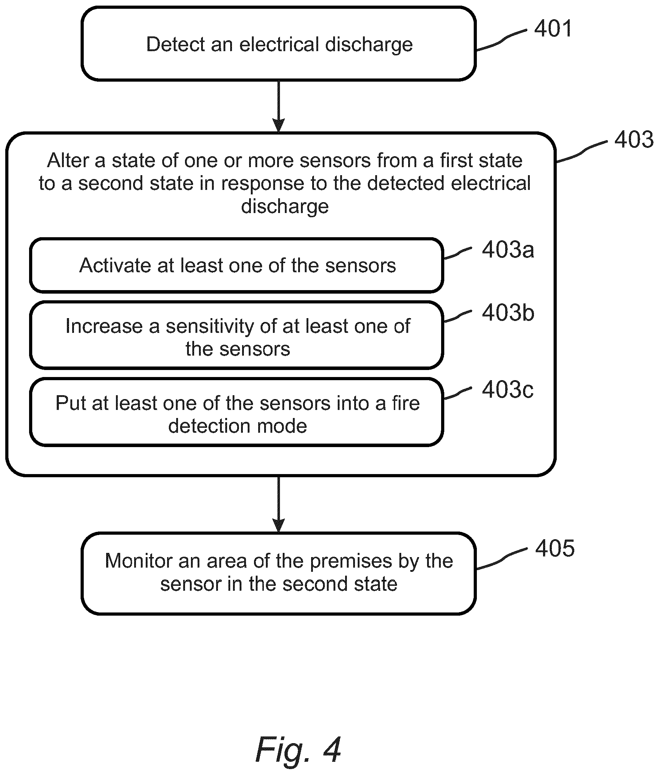

Fig. 4 shows a method of operating the security monitoring system 100 in response to the detection of an electrical discharge by the electrical discharge detector 108. In particular, when a signal is received from the electrical discharge detector 108 that an electrical discharge has been detected (i.e. the signal transmitted in step 309), the security monitoring system 100 may alter a state of one or more sensors 101 (e.g. one or more sensors 101 monitoring an interior area of the premises 120) of the security monitoring system. Importantly, the electrical discharge detector 108 is configured to be active irrespective of whether the security monitoring system 100 is in an armed or disarmed state (i.e. the electrical discharge detector 108 is substantially always active), and the security monitoring system 100 may accordingly alter the state of the sensors 101 even if the system is in a disarmed state (e.g. if occupants are in the premises) where the sensors 101 are not normally active. This is of particular importance considering that fires in the premises 120 are most dangerous when occupants are present in the premises 120 and the security monitoring system 100 accordingly is disarmed.

The security monitoring system 100 can accordingly (i) be made even more alert in case a fire breaks out so as to further improve potential fire detection performance, (ii) focus the sensors 101 primarily on fire or spark recognition or detection, and/or (iii) reduce the risk of unnecessarily calling the emergency services. Hence, a risk of a devastating fire event may potentially be reduced.

In step 401, the electrical discharge detector 108 detects a likely electrical discharge which could be a precursor to a fire. The electrical discharge detector 108 may detect the electrical discharge according to the method of Fig. 3 or any other suitable method. Once an electrical discharge has been detected, the electrical discharge detector 108 transmits a signal to the security monitoring system 100 (e.g. to the control unit 110 and/or directly to one or more sensors 101) and/or the remote monitoring centre 113.

In step 403, a state of one or more sensors 101 of the security monitoring system 100 is altered in response to the transmitted signal. The state may be altered from a first state (e.g. a default state and/or disarmed state) to a second state. The second state may be a state where an alertness level of the sensor 101 is increased.

The one or more sensors 101 that are altered may be any sensor 101 previously described in relation to the security monitoring system 100 or any other sensor 101 part of or connected to the security monitoring system 100.

The sensor(s) 101 may be configured to alter their state upon receiving the signal directly from the electrical discharge detector 108. Alternatively, or additionally, the sensor(s) 101 may be instructed by the control unit 110 and/or the remote monitoring centre 113 to alter their state (e.g. in response to the control unit 110 and/or the remote monitoring centre 113 receiving the signal from the electrical discharge detector 108).

In step 405, the one or more sensors 101 in the altered state may be configured to provide (enhanced) monitoring of an area (e.g. an interior area) of the premises 120. Hence, the sensors in the altered state may allow detection of a potential fire (and/or a precursor to a fire) in the premises 120. Accordingly, a potential fire detection performance of the security monitoring system 100 is improved. The monitoring may be performed by the sensor 101 in the second state directly. The monitoring may alternatively or additionally be performed elsewhere in dependence on monitoring data transmitted from the sensor 101 in the second state, e.g. by an operator (e.g. located at the remote monitoring centre 113) and/or automatically (e.g. by a processor of the control unit 110).

If the monitoring by the sensor 101 in the second state indicates that a potential fire may have started in the premises 120, an alert signal may be generated and transmitted. The alert signal may be transmitted to the control unit 110, the remote monitoring centre 113 (e.g. via the control unit 110), one or more user devices 112, and/or directly to the emergency services (e.g. the fire brigade). In response to the alert signal, an alarm may be raised. For example, a siren or other alarm indicator 109 in the premises 120 may be triggered.

If, on the other hand, it is determined that the detection of an electrical discharge was a false alarm (i.e. a false positive), the sensor 101 may revert to the original state without transmitting an alert signal. Similarly, if the cause of the electrical discharge is identified and resolved (e.g. by a qualified electrician), the sensor 101 may revert to its original state.

The altering of a sensor state in step 403 may comprise any one or more of the sub-steps 403a, 403b, and/or 403c.

In step 403a, the one or more sensors 101 are activated, turned on, or woken up. In other words, the altering of the sensor state comprises activating, waking up and/or turning on the one or more sensor 101. For example, the sensor 101 may be woken up or activated from a sleep state, a turned off state, or a disarmed state.

The sensor 101, once activated, may be configured to monitor an area of the premises and/or to transmit monitoring data to the control unit 110, the remote monitoring centre 113, and/or a user device 112 following the detected electrical discharge. Hence, an alertness and/or potential fire detection performance of the security monitoring system 100 may be increased, and the emergency services may, if necessary, be notified at an appropriate time.

For example, an image capturing sensor 104 (e.g. a sensor 101 comprising a photographic and/or video camera) may be activated in step 403a so as to provide and/or obtain one or more (still and/or moving) images of its field of view. Generally, the image capturing sensor 104 may only capture images in response to a PIR sensor detecting a potential intruder in the premises 120, however, the security monitoring system may in step 403a force the image capturing sensor 104 to enter an activated state.

The images provided (e.g. captured or obtained) by the image capturing sensor 104 may be transmitted to a user (e.g. to an app on a user device 112) such that the user (who may not be present in the premises 120) can view the images to monitor if a fire has started in the premises 120. The images may alternatively or additionally be sent to the remote monitoring centre 113 for visual monitoring of the premises 120. For instance, an operator at the remote monitoring centre 120 may monitor the images to see if a potential fire has started and/or an image analyser may be used to analyse the images to determine if a potential fire has started. In some embodiments, the image capturing sensor 104 may provide a live feed of the premises 120 which may be viewed and/or analysed, e.g. by a user or operator.

As another example, a thermal radiation-based sensor 107 (e.g. a photosensor such as an infrared sensor, e.g. PIR sensor) may be activated. Such a sensor 101 may be used to monitor an amount an incident infrared light (or other thermal radiation). Similarly, a temperature sensor 106 may be activated to monitor the temperature within the premises 120. The amount of incident thermal radiation and/or the temperature may be indicative of whether a potential fire has started. Measurements and/or readings from the sensors 101 may be transmitted to the security monitoring system 100 where monitoring may be performed by operators and/or automatically. It is noted that the temperature sensor 106 may otherwise only be active (and/or configured to transmit readings) upon request by a user (e.g. whenever the user opens the app on a user device 112 to check the temperature inside the premises 120).

In step 403b, which may be performed in addition to or separately from step 403a, a sensitivity of the one or more sensors 101 is increased. In other words, the sensor 101 is altered to a state in which the sensor 101 has a higher sensitivity. For example, the sensor 101 may be altered from a low-sensitivity, default, armed, disarmed and/or inactivated state into a high-sensitivity state.

As an example, a sensitivity level of a smoke detecting sensor 105 (which is generally always active) may be altered such that the smoke detecting sensor 105 has an increased sensitivity to smoke. For example, a smoke detection threshold for triggering an alarm may be decreased. Hence, the smoke detecting sensor 105 may provide an alert signal (e.g. by sirens or the like) even if only a small amount of smoke is detected.

In step 403c, which may be performed in addition to or separately from steps 403a and/or 403b, one or more sensors 101 are put into a fire detection mode. For example, the sensor 101 may be altered from a default, armed, disarmed and/or inactive state and put into the fire detection mode. In the fire detection mode, the sensors 101 may be specifically configured to prioritise data (e.g. input data or monitoring data) that may be indicative of a potential fire in the premises.

As an example, an image capturing sensor 104 (e.g. a photographic or video camera) may be put into the fire detection mode. In the fire detection mode, the image capturing sensor 104 may provide monitoring of its field of view to determine whether one or more colours present in the images are indicative of a potential fire in the field of view of the image capturing sensor 104. For example, the image capturing means may be configured to capture (still or moving) images comprising colour data. As another example, the image capturing sensor 104 may provide a live feed of its field of view, which can be used to determine if target colour(s) are (sufficiently) present. The security monitoring system 100 can accordingly alert occupants (e.g. through a siren) as well as the remote monitoring centre 113 and/or the emergency services when a potential fire is detected.

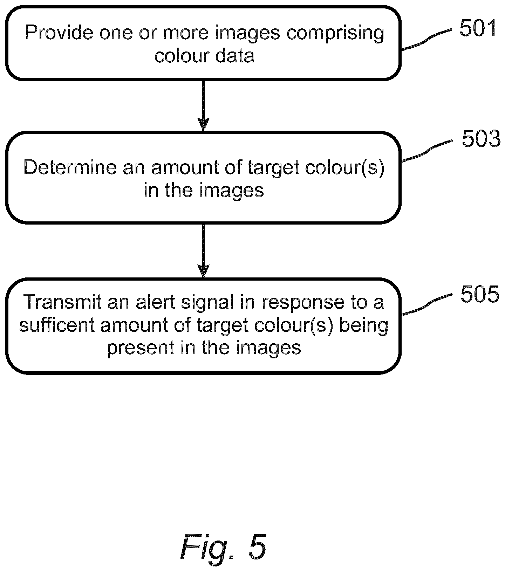

In particular, a method of operating the security monitoring system 100 with image capturing sensor 104 in fire detection mode is shown in Fig. 5. The method of Fig. 5 may be performed after the image capturing sensor 104 has been put into a fire detection mode in step 403c of Fig. 4.

In step 501, the image capturing sensor 104 may provide (e.g. capture) one or more (still and/or moving) images comprising colour data. The images may represent the field of view of the image capturing sensor 104. The image capturing sensor 104 may be configured to provide or capture images over a period of time (e.g. continuously, at regular intervals or the like) to allow monitoring of the premises over an extended period of time. In some embodiments, the images are provided in the form of a video recording and/or a live feed.

In particular, the one or more images representing the field of view of the image capturing sensor 104 may comprise colour data relating to one or more target colours. The target colours may include colours that are indicative of fire potentially being present in the image or field of view. For example, the target colours may include red, yellow and/or orange.

In some embodiments, the image capturing sensor 104 is, in the fire detection mode, configured to be more sensitive to one or more target colours (e.g. red, orange and/or yellow wavelengths) than to one or more other colours (e.g. blue or green wavelengths).

In step 503, it is determined whether an amount of one or more target colours in the image(s) indicates that there is a potential fire in the premises 120. For instance, the system may determine whether an amount of one or more target colours is higher than a threshold. The threshold may be set in dependence on colour data of one or more reference images (e.g. image(s) taken previously by the image capturing sensor 104). Accordingly, the amount of target colours may be compared to colour data of one or more reference images to determine if a potential fire may have started in the premises 120. As another example, the system may determine whether an amount of one or more target colours increases (e.g. a sudden increase and/or an increase by a predetermined amount).

The determination may be made using algorithms or other automatic determination means. In some embodiments, the determination may be improved by machine learning techniques and/or artificial intelligence that have been trained on reference images (e.g. images captured previously be the image capturing sensor).

The determination may be made by a processor of the image capturing sensor 104, or the image capturing sensor 104 may be configured to transmit the images and/or the colour data associated with said images to the control unit 110, a user device 112 and/or the remote monitoring centre 113, which in turn may determine whether the colour data of the images is indicative of a potential fire.

In step 505, once the images start showing colours indicative of a potential fire, an alert signal may be generated and transmitted in accordance with step 405 of Fig. 4.

Returning to Fig. 4, and in particular step 403c, another example includes one or more temperature sensors 106 being put into a fire detection mode. In the fire detection mode, the temperature sensor 106 may be configured to continuously (and/or repeatedly) monitor a temperature inside the premises 120 so as to detect if and when the temperature increases or changes in a way consistent with or indicative of a potential fire having started within the premises 120.

For example, a temperature threshold may be set, or if a threshold already exists, the threshold may be lowered (i.e. to increase the sensitivity), such that an alert signal is triggered when the temperature exceeds the threshold. As another example, the system may identify a sudden increase in temperature (e.g. a predetermined temperature rise within a predetermined time period).

As yet another example, one or more a thermal radiation-based sensor 107 (e.g. a photosensor, an infrared sensor, a PIR sensor) may be put into a fire detection mode. Such a sensor 101 may be used to monitor an amount an incident infrared light (or other thermal radiation) and compare the amount of incident infrared light to a reference or threshold amount, in order to determine if the amount of incident infrared light has increased in a way indicative of a fire having started within the premises 120.

For example, a radiation threshold may be set, or if a threshold already exists, the threshold may be lowered (i.e. to increase the sensitivity), such that an alert signal is triggered when the radiation exceeds the threshold. As another example, the system may identify a sudden increase in incident radiation (e.g. a predetermined increase in incident radiation within a predetermined time period). As yet another example, the sensor (e.g. a PIR sensor) may be configured to detect a stark thermal contrast between adjacent areas of its field of view.

The thermal radiation-based sensor 107 may accordingly detect a fire even if the line of sight is obstructed by certain materials (e.g. materials which may be opaque to visible light but transparent to infrared light).

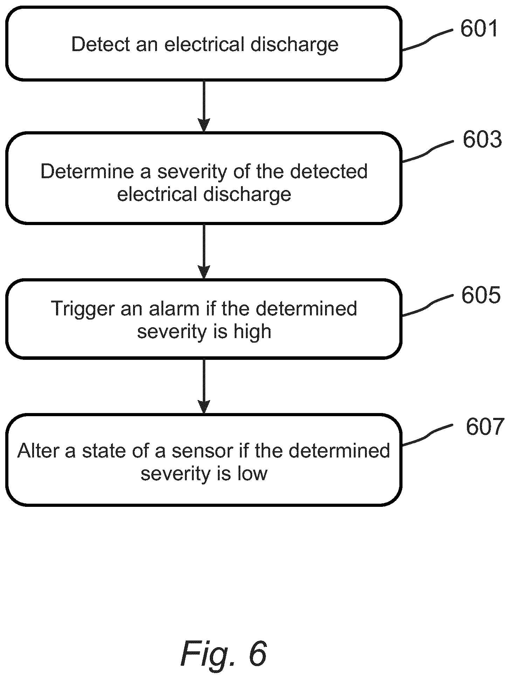

Fig. 6 shows a further method of operating the security monitoring system 100 in which a severity of a detected electrical discharge is determined. The security monitoring system 100 may be configured to take action in dependence on the determined severity of the detected electrical discharge. For example, if the determined severity exceeds a threshold, the security monitoring system 100 may directly start an alarm indicator 109 (e.g. a siren) within the premises 120 to notify occupants of the electrical discharge and/or the security monitoring system 100 may directly notify the emergency services. Conversely, if the determined severity is below the threshold, the security monitoring system 100 may alter the state of one or more sensors 101 in accordance with Fig. 4 to provide enhanced monitoring of the premises 120. In particular, the method of Fig. 6 comprises the following steps:
In step 601, the electrical discharge detector 108 detects an electrical discharge which could potentially be a precursor to a fire. The detection in step 601 is substantially equivalent to the detection as described in relation to step 401 of Fig. 4.
In step 603, the system is configured to determine a severity of the detected electrical discharge.

For example, the electrical discharge detector 108 may compare the transient characteristics of the identified transient signal to reference characteristics (e.g. previously detected electrical discharges) for electrical discharges with varying or different severity. Further, any machine learning techniques used in analysing the transient characteristics may be trained on data for electrical discharges of different severity allowing the analysing techniques to determine whether the identified transient signal corresponds to, e.g. an electrical discharge of relatively low severity or of relatively high severity.

Alternatively, or additionally, the electrical discharge detector 108 may infer the severity of an electrical discharge from the frequency and/or number of detected electrical discharges. For example, if the electrical discharge detector detects several electrical discharges over a period of time, it may be inferred that a later electrical discharge has higher severity than an earlier electrical discharge (because the fault in the electrical wiring causing the electrical discharges is likely to become worse over time). Accordingly, the electrical discharge detector 108 may be configured to infer that the severity is high after a predetermined number of electrical discharges have been detected within a set time frame.

In step 605, an alarm is triggered in dependence on the severity of the detected electrical discharge exceeding a threshold. The triggering of the alarm may involve setting off a siren and/or other alarm indicator 109 in the premises 120, and/or notifying the emergency services.

In addition to the triggering of the alarm in step 605, and/or if the determined severity is below the threshold, a state of at least one sensor 101 may be altered in step 607 (which substantially corresponds to step 403 of Fig. 4). It will be appreciated that in some embodiments, step 607 may optionally only be performed if the determined severity is below the threshold.

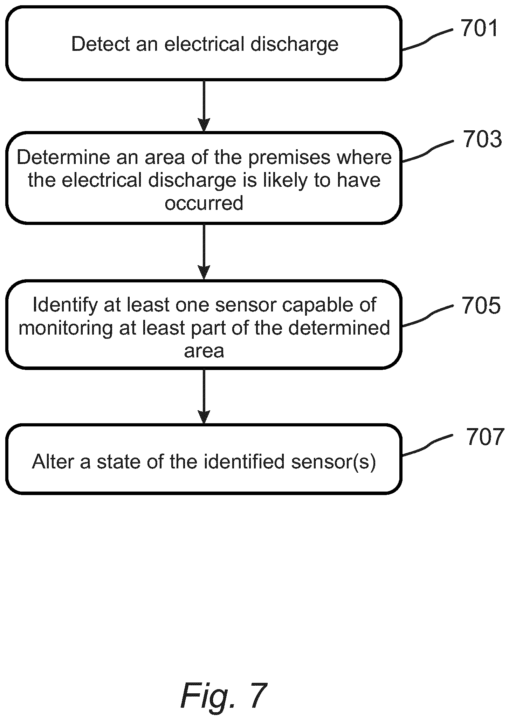

Fig. 7 shows a yet further method of operating the security monitoring system 100 where the system is configured to determine an area of the premises 120 within which the electrical discharge has likely occurred. The security monitoring system 100 used in the method of Fig. 7 is substantially identical to the previously described security monitoring system 100 but has an additional electrical discharge detector 108 connected to another outlet 203 of the electrical wiring. In other words, the security monitoring system 100 of Fig. 7 comprises first and second electrical discharge detectors 108.

In step 701, at least one of the electrical discharge detectors 108 detects an electrical discharge which could be a precursor to a fire. The detection in step 701 is substantially equivalent to the detection in step 401 of Fig. 4.

In step 703, the system is configured to determine a likely area of the premises 120 within which the electrical discharge occurred.

The area of the premises 120 in which the electrical discharge is likely to have occurred may be determined using time-of-arrival techniques for the transient signals identified by the electrical discharge detectors 108. In particular, a time difference between the arrival of a transient signal at a first electrical discharge detector 108 and the arrival of the same transient signal at a second electrical discharge detector 108 may be used to determine a relative distance for each of the electrical discharge detectors 108 to the location of the electrical discharge. In particular, the two electrical discharge detectors 108 can use the pulse shape to recognise the relevant transient signal caused by the electrical discharge (from the remaining signal), and accordingly calculate a time difference between the arrival of the (same) relevant transient signal for the two electrical discharge detectors 108.

The security monitoring system 100 may thereafter determine a likely area of the premises in dependence on where the two electrical discharge detectors 108 are located and the layout of the electrical wiring in the premises 120.

In step 705, the security monitoring system 100 identifies one or more of its sensors 101 that monitors or is located in at least part of the determined area.

In step 707, a state of the identified sensor(s) 101 is altered. Once the state has been altered, the sensor 101 may be configured to monitor at least part of the determined area so as to allow detection of a potential fire (and/or a precursor to a fire) in the premises 120, in accordance with step 403 of Fig. 4.

If the monitoring by the sensor 101 in the second state indicates that a potential fire may have started in the premises 120, an alert signal is transmitted.

It will be understood that the methods of Figs. 4 to 7 may be combined and/or performed individually. The various embodiments described above are provided by way of illustration only and should not be construed to limit the invention. For example, the principles herein may be applied to any alarm system or security monitoring system. Those skilled in the art will readily recognize various modifications and changes that may be made to the present invention without following the example embodiments and applications illustrated and described herein, and without departing from the scope of the present disclosure.

Throughout this specification, the word "may" is used in a permissive sense (i.e. meaning having the potential to), rather than in the mandatory sense (i.e. meaning must).

Throughout this specification, the words "comprise", "include", and variations of the words, such as "comprising" and "comprises", "including", "includes", do not exclude other elements or steps.

As used throughout this specification, the singular forms "a", "an", and "the", include plural referents unless explicitly indicated otherwise. Thus, for example, reference to "an" element also includes a combination of two or more elements, notwithstanding use of other terms and phrases for one or more elements, such as "one or more" or "at least one".

The term "or" is, unless indicated otherwise, non-exclusive, i.e. encompassing both "and" and "or". For example, the feature "A or B" includes feature "A", feature "B" and feature "A and B".

Unless otherwise indicated, statements that one value or action is "based on", "in response to" and/or "in dependence on" another condition or value or action, encompass both instances in which the condition or value or action is the sole factor and instances where the condition or value or action is one factor among a plurality of factors.

Unless otherwise indicated, statements that "each" instance of some collection have some property should not be read to exclude cases where some otherwise identical or similar members of a larger collection do not have the property, i.e. each does not necessarily mean each and every.

## Claims

1. A method of operating a security monitoring system of a premises, the method comprising:
detecting, by an electrical discharge detector of the security monitoring system, an electrical discharge in electrical wiring of the premises; and
in response to the detection, altering a state of at least one sensor of the security monitoring system from a first state to a second state.

2. The method according to claim 1, wherein the method further comprises monitoring, using the sensor in the second state, an area of the premises.

3. The method according to claim 1 or 2, wherein the altering of the at least one sensor from the first state to the second state comprises any one or more of:
activating the sensor;
increasing the sensitivity of the sensor; and
putting the sensor into a fire detection mode.

4. The method according to any preceding claim, wherein the at least one sensor comprises a presence sensor, a thermal sensor, a radiation-based sensor, an infrared sensor, a motion sensor, a photosensor, a smoke detection sensor, a temperature sensor, an image capturing sensor, or any combination thereof.

5. The method according to any preceding claim, wherein the sensor in the second state is configured to monitor a parameter indicative of a potential fire in the premises.

6. The method according to claim 5, comprising transmitting an alert signal in response to a value of the parameter being indicative that a fire has potentially started in the premises.

7. The method according to any preceding claim, wherein at least one of the sensors comprises a temperature sensor,
wherein the temperature sensor in the second state is configured to monitor a temperature in the premises,
optionally, wherein the method comprises transmitting an alert signal in response to the monitored temperature exceeding a temperature threshold,
optionally, wherein the temperature threshold in the second state is lower than a temperature threshold in the first state.

8. The method according to any preceding claim, wherein at least one of the sensors comprises a thermal radiation-based sensor, such as an infrared sensor,
wherein the thermal radiation-based sensor in the second state is configured to monitor an amount of incident thermal radiation,
optionally, wherein the method comprises transmitting an alert signal in response to the amount of incident thermal radiation exceeding a radiation threshold,
optionally, wherein the incident thermal radiation threshold in the second state is lower than an incident thermal radiation threshold in the first state.

9. The method according to any preceding claim, wherein at least one of the sensors comprises a smoke detection sensor configured to detect smoke, the smoke detection sensor having a smoke detection threshold,
optionally, wherein the smoke detection sensor in the second state has a lower smoke detection threshold than the smoke detection threshold in the first state,
optionally, wherein the method comprises transmitting an alert signal in response to the smoke detected exceeding the smoke detection threshold.

10. The method according to any preceding claim, wherein at least one of the sensors comprises an image capturing sensor,
wherein the method further comprises determining an amount of target colours in a field of view of the image capturing sensor,
optionally, wherein the method further comprises transmitting an alert signal in response to the determined amount exceeding a target colour threshold.

11. The method according to any preceding claim, wherein the method further comprises:
determining a severity of the detected electrical discharge; and
in response to the determined severity exceeding a severity threshold, triggering an alarm,
optionally, wherein the triggering of the alarm comprises activating a siren within the premises.

12. The method according to any preceding claim, wherein the method further comprises:
determining an area of the premises in which the electrical discharge has occurred, and
identifying at least one sensor of the security monitoring system configured to monitor at least part of the determined area,
wherein the sensor that is altered from the first state to the second state comprises the identified sensor.

13. The method according to any preceding claim, wherein the electrical discharge detector comprises a plug inserted into an outlet of the electrical wiring.

14. The method according to any preceding claim, wherein the step of detecting the electrical discharge comprises:
measuring an electrical signal waveform of the electrical wiring;
identifying one or more transient signals within the waveform; and
determining an occurrence of the electrical discharge in dependence on transient characteristics of the one or more transient signals.

15. A security monitoring system for monitoring of a premises, the security monitoring system comprising:
at least one electrical discharge detector configured to be connected to an outlet of electrical wiring in the premises, wherein the electrical discharge detector is configured to detect an electrical discharge in the electrical wiring; and
at least one sensor configurable between a first state and a second state;
wherein the system is configured to alter the sensor from the first state to the second state in response to detection of an electrical discharge by the electrical discharge detector.
